Europäisches Patentamt

(19) European Patent Office

Office européen des brevets

(11) **EP 1 010 236 B1**

(12) **EUROPÄISCHE PATENTSCHRIFT**

(45) Veröffentlichungstag und Bekanntmachung des Hinweises auf die Patenterteilung:
**05.12.2001 Patentblatt 2001/49**

(21) Anmeldenummer: **98952507.6**

(22) Anmeldetag: **27.08.1998**

(51) Int Cl.[7]: **H03B 5/12**

(86) Internationale Anmeldenummer:
**PCT/DE98/02515**

(87) Internationale Veröffentlichungsnummer:
**WO 99/12255 (11.03.1999 Gazette 1999/10)**

(54) **OSZILLATORSCHALTUNG MIT EINEM SCHWINGQUARZ**

OSCILLATORY CIRCUIT WITH PIEZOELECTRIC QUARTZ

CIRCUIT OSCILLATEUR A QUARTZ PIEZOELECTRIQUE

(84) Benannte Vertragsstaaten:
**DE FR GB**

(30) Priorität: **04.09.1997 DE 19738718**

(43) Veröffentlichungstag der Anmeldung:
**21.06.2000 Patentblatt 2000/25**

(73) Patentinhaber: **Infineon Technologies AG 81669 München (DE)**

(72) Erfinder: **KUTTNER, Franz A-9524 St. Ulrich (AT)**

(74) Vertreter: **Zedlitz, Peter, Dipl.-Inf. et al Patentanwalt, Postfach 22 13 17 80503 München (DE)**

(56) Entgegenhaltungen:
EP-A- 0 431 887          EP-A- 0 563 945
EP-A- 0 564 377          US-A- 5 457 433

EP 1 010 236 B1

## Beschreibung

Die Erfindung betrifft eine Oszillatorschaltung mit einem Schwingquarz.

Aus der US-A-5 457 433, der EP 0 431 887 A2, der EP 0 641 980 A2 und der US 4,941,156 A sind jeweils Oszillatorschaltungen bekannt, die zwischen einem ersten einem zweiten Schaltungsknoten eine Parallelschaltung aus einem Schwingquarz, einem Inverter und einem Widerstandselement aufweisen. Jeder der Schaltungsknoten ist über wenigstens einen Kondensator mit Masse verbunden. Wenigstens einer der Schaltungsknoten weist eine Parallelschaltung einer größeren Anzahl von Kondensatoren auf, die mittels Schaltern zu- oder abgeschaltet werden können. Auf diese Weise kann die Frequenz der Oszillatorschaltung eingestellt werden.

Wenn das Zu- oder Abschalten der Kondensatoren zu beliebigen Zeitpunkten während des Betriebs der Oszillatorschaltung erfolgt, kommt es aufgrund der sprunghaften Veränderung der Gesamtkapazität am entsprechenden Schaltungsknoten zu einer unvorhersehbaren Beeinflussung der erzeugten Schwingung im Schaltzeitpunkt.

Der Erfindung liegt die Aufgabe zugrunde, eine Oszillatorschaltung der eingangs genannten Art anzugeben, bei der der Schaltzeitpunkt für das Zu- beziehungsweise das Abschalten der Kondensatoren sich automatisch so einstellt, daß das Verhalten der Oszillatorschaltung sehr gut voraus berechnet werden kann.

Diese Aufgabe wird mit einer Oszillatorschaltung gemäß Anspruch 1 gelöst. Ausführungen und Weiterbildungen der Erfindung sind in abhängigen Ansprüchen gekennzeichnet.

Die Oszillatorschaltung weist zwischen einem ersten und einem zweiten Schaltungsknoten eine Parallelschaltung aus einem Schwingquarz, einem ersten Inverter und einem ersten Widerstandselement auf. Der erste Schaltungsknoten ist über eine erste Kondensatorschaltung und der zweite Schaltungsknoten über eine zweite Kondensatorschaltung mit einem Bezugspotential verbunden. Die erste Kondensatorschaltung weist wenigstens zwei Kondensatoren mit je einem ersten und einem zweiten Anschluß auf, deren erster Anschluß mit dem Bezugspotential und deren zweiter Anschluß über je ein Schaltelement mit dem ersten Schaltungsknoten verbunden ist. Außerdem ist vorgesehen, daß die Oszillatorschaltung eine Synchronisierschaltung zur Erzeugung eines Synchronisiersignals aufweist, das ein Schalten wenigstens eines der Schaltelemente der ersten Kondensatorschaltung in Abhängigkeit von einem Potential am ersten Schaltungsknoten auslöst.

Bei der erfindungsgemäßen Oszillatorschaltung erfolgt ein Einstellen der Frequenz durch eine Betätigung der Schaltelemente, wodurch eine unterschiedliche Anzahl der Kondensatoren der ersten Kondensatorschaltung zwischen dem ersten Schaltungsknoten und dem Bezugspotential zueinander parallel geschaltet werden. Die Synchronisierung hat den Vorteil, daß während des Betriebs der Oszillatorschaltung ein Wechsel der Betriebsfrequenz durch Schalten der Schaltelemente zu einem Zeitpunkt durchführbar ist, der durch das Schwingverhalten der Oszillatorschaltung selbst bestimmt wird. Somit kann das Verhalten der Oszillatorschaltung vor und nach dem Schalten wenigstens eines der Schaltelemente während des Betriebs sehr gut vorausberechnet werden.

Bei einer Weiterbildung der Erfindung weist die Oszillatorschaltung zusätzlich zur Synchronisierschaltung eine Vorladeschaltung zur Erzeugung eines Vorladepotentials auf, die mit einem dritten Schaltungsknoten verbunden ist. Die Schaltelemente der ersten Kondensatorschaltung haben dabei einen ersten Schaltzustand, in dem sie den zweiten Anschluß des jeweiligen Kondensators mit dem ersten Schaltungsknoten verbinden und einen zweiten Schaltzustand, in dem sie den zweiten Anschluß des Kondensators mit dem dritten Schaltungsknoten verbinden. Die Vorladeschaltung hat den Vorteil, daß die Kondensatoren der ersten Kondensatorschaltung, deren Schaltelemente sich im zweiten Schaltzustand befinden, auf ein definiertes Vorladepotential vorgeladen werden, so daß bei einem Zuschalten der Kondensatoren während des Betriebs der Oszillatorschaltung, d. h. einem Frequenzwechsel, das Potential am ersten Schaltungsknoten in vorhersagbarer Weise im wesentlichen durch das festgelegte Vorladepotential beeinflußt wird.

Es ist besonders vorteilhaft, wenn die Synchronisierschaltung nach einer Weiterbildung der Erfindung ein Schalten der Schaltelemente genau dann auslöst, wenn das Potential am ersten Schaltungsknoten im wesentlichen mit dem Vorladepotential am dritten Schaltungsknoten, auf das die damit verbundenen Kondensatoren der ersten Kondensatorschaltung vorgeladen sind, übereinstimmt. Beim Zuschalten weiterer Kondensatoren an den ersten Schaltungsknoten kommt es dann zu keinerlei Beeinflussung des Potentials am ersten Schaltungsknoten. Es ergibt sich dadurch ein praktisch störungsfreies Schwingverhalten der Oszillatorschaltung auch bei während des Betriebs durchgeführten Frequenzwechseln.

Zur Durchführung des Vergleichs zwischen dem Potential am ersten Schaltungsknoten und dem Vorladepotential kann die Synchronisierschaltung beispielsweise einen entsprechenden Komparator aufweisen. Eine einfachere und sehr vorteilhafte Realisierungsform der Synchronisierschaltung wird weiter unten anhand des Ausführungsbeispiels erläutert.

Die Erfindung wird im folgenden anhand der Figuren näher erläutert. Es zeigen:

| | |
|---|---|
| Figur 1 | ein Ausführungsbeispiel der Erfindung, |
| Figuren 2 und 3 | Signalverläufe zu der Schaltung aus Figur 1. |

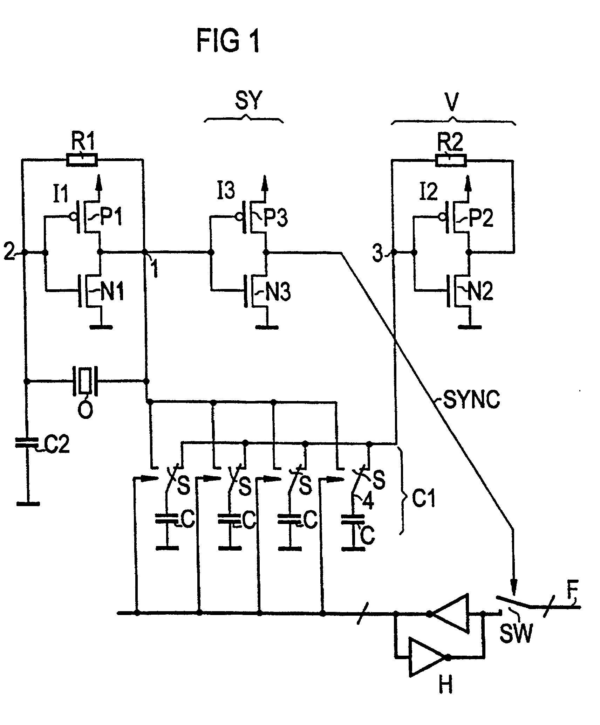

Die Oszillatorschaltung in Figur 1 weist einen ersten Schaltungsknoten 1 auf, der über einen Schwingquarz 0 mit einem zweiten Schaltungsknoten 2 verbunden ist. Dem Schwingquarz 0 ist ein erster CMOS-Inverter I1 und ein erstes Widerstandelement R1 parallelgeschaltet. Der erste Schaltungsknoten 1 ist über eine erste Kondensatorschaltung C1 und der zweite Schaltungsknoten 2 über eine zweite Kondensatorschaltung C2 in Form eines einzelnen Kondensators mit Masse verbunden.

Die erste Kondensatorschaltung C1 weist eine Vielzahl von Kondensatoren C auf, von denen nur vier dargestellt sind. Eine erste Elektrode der Kondensatoren C ist mit Masse verbunden, während eine zweite Elektrode mit je einem Schaltelement S verbunden ist. Die Schaltelemente S haben zwei Schaltzustände: einen ersten Schaltzustand, in dem sie die zweite Elektrode des jeweiligen Kondensators C mit dem ersten Schaltungsknoten 1 verbinden und einen zweiten Schaltzustand, in dem sie den zweiten Anschluß mit einem dritten Schaltungsknoten 3 verbinden. In Figur 1 befinden sich die eingezeichneten Kondensatoren C alle im zweiten Schaltzustand.

Der Schaltzustand der Schaltelemente S in Figur 1 wird bestimmt durch entsprechende digitale Steuersignale auf einem Steuerbus F. Die Oszillatorschaltung schwingt, wenn die Spannungsversorgung des ersten Inverters I1 eingeschaltet ist und wenigstens einer der Kondensatoren C über sein Schaltelement S mit dem ersten Schaltungsknoten 1 verbunden ist. Über den Steuerbus F kann dann bei einer ausreichenden Anzahl an Kondensatoren C die Frequenz der Oszillatorschaltung in einem großen Bereich beliebig feinstufig verändert werden.

Während die bisher beschriebenen Komponenten für sich genommen schon einen Betrieb der Oszillatorschaltung ermöglichen, weist diese gemäß Figur 1 noch weitere Komponenten auf, nämlich eine Vorladeschaltung V und eine Synchronisierschaltung SY. Die Vorladeschaltung V weist einen zweiten CMOS-Inverter I2 auf, dessen Eingang mit dem dritten Schaltungsknoten 3 verbunden ist und dessen Eingang über ein zweites Widerstandselement R2 mit seinem Ausgang verbunden ist. Die Sychronisierschaltung SY weist einen dritten CMOS-Inverter I3 auf, dessen Eingang mit dem ersten Schaltungsknoten 1 und dessen Ausgang, an dem ein Synchronisiersignal SYNC erzeugt wird, mit einem Steueranschluß eines Schalters SW verbunden ist. Der Schalter SW schaltet zu durch das Synchronisiersignal SYNC bestimmten Zeitpunkten die Signale auf dem Steuerbus F durch, die in einer Halteschaltung H gespeichert werden, so daß auch bei geöffnetem Schalter SW der zuletzt auf dem Steuerbus F anliegende Zustand gespeichert wird. Die Transistoren des ersten Inverters I1, des zweiten Inverters I2 und des dritten Inverters I3 sind jeweils so dimensioniert, daß für sie alle der Quotient aus dem Weiten-zu-Längen-Verhältnis des p-Kanal-Transistors und dem Weiten-zu-Längen-Verhältnis des n-Kanal-Transistors im wesentlichen übereinstimmt. Das heißt, es gilt:

$$\frac{\left(\dfrac{W_{P1}}{L_{P1}}\right)}{\left(\dfrac{W_{N1}}{L_{N1}}\right)} = \frac{\left(\dfrac{W_{P2}}{L_{P2}}\right)}{\left(\dfrac{W_{N2}}{L_{N2}}\right)} = \frac{\left(\dfrac{W_{P3}}{L_{P3}}\right)}{\left(\dfrac{W_{N3}}{L_{N3}}\right)}$$

Da der beschriebene Quotient bei CMOS-Invertern grundsätzlich den Gleichspannungsarbeitspunkt bestimmt, ist dieser für alle drei Inverter I1, I2, I3 gleich. Da der zweite Inverter I2 der Vorladeschaltung V während des Betriebs der Oszillatorschaltung nahezu immer im Gleichspannungsarbeitspunkt betrieben wird, weil er nicht schwingt, ist das Vorladepotential am dritten Schaltungsknoten 3 identisch mit diesem Gleichspannungsarbeitspunkt. Aufgrund der gleichen Arbeitspunkte, die den Schaltpunkten der Inverter I1, I2, I3 entsprechen, schaltet der dritte Inverter I3 der Synchronisierschaltung SY, sobald der erste Inverter I1 und damit das Potential am ersten Schaltungsknoten 1 den Gleichspannungsarbeitspunkt durchschreitet.

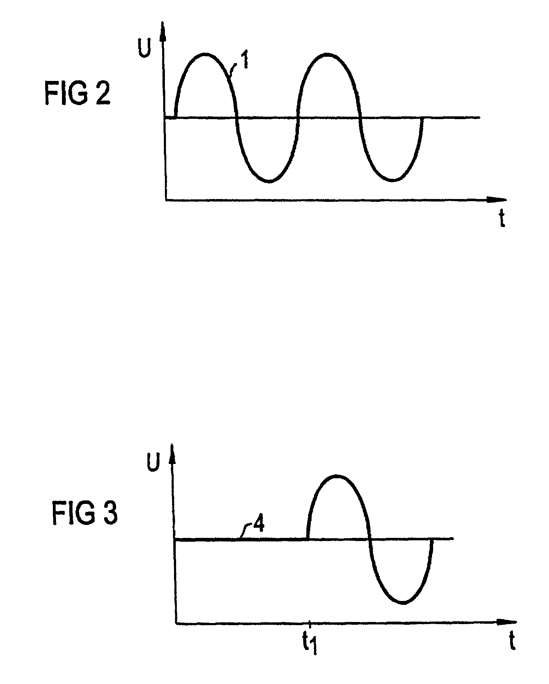

Figur 2 zeigt das Potential am ersten Schaltungsknoten 1, während Figur 3 das Potential an einem vierten Schaltungsknoten 4, der mit der zweiten Elektrode des Kondensators C ganz rechts in Figur 1 verbunden ist, zeigt. In Figur 2 und Figur 3 bezeichnet die waagerechte Linie jeweils den DC-Arbeitspunkt der Inverter I1, I2, I3. Der Kondensator C ist gemäß Figur 3 bis zu einem Zeitpunkt $t_1$ über sein Schaltelement S mit dem dritten Schaltungsknoten 3 verbunden und wird daher auf das Vorladepotential, was gleich dem DC-Arbeitspunkt ist, vorgeladen. Zum Zeitpunkt $t_1$ erkennt der dritte Inverter I3 den "Nulldurchgang" des Potentials am ersten Schaltungsknoten 1 und schaltet sofort ebenfalls um. Über das Synchronisiersignal SYNC wird der Schalter SW umgeschaltet (also geschlossen bzw. geöffnet), so daß auf dem Steuerbus F anliegende digitale Signale zur Halteschaltung H durchgeschaltet bzw. von dieser getrennt werden. Die digitalen Signale bewirken beim betrachteten Beispiel ein Schalten des Schaltelementes S des betrachteten Kondensators C ganz rechts in Figur 1, so daß dessen zweite Elektrode nun mit dem ersten Schaltungsknoten 1 verbunden ist, so daß sein Potential mit demjenigen des vierten Schaltungsknotens 4 übereinstimmt. Dies ist in Figur 3 ab dem Zeitpunkt $t_1$ ersichtlich. Der durch das Zuschalten des Kondensators C im Zeitpunkt $t_1$ bewirkte Frequenzwechsel der Schwingung am Schaltungsknoten 1 wurde in den Figuren 2 und 3 nicht dargestellt.

Um nahezu identische Gleichspannungsarbeitspunkte der drei Inverter I1, I2, I3 und damit nahezu identische Quotienten der Weiten-zu-Längen-Verhältnisse ihrer Transistoren zu erreichen, weisen ihre p- bzw. n-Kanal-Transistoren jeweils dasselbe Design bzw. Layout (geometrische Abmessungen in der integrierten Schaltung) auf. Da der erste Inverter I1 einen größeren Strom liefern muß als der zweite Inverter I2 und der dritte Inverter I3, sollten seine Transistoren jedoch größer als diese dimensioniert werden. Dies läßt sich dadurch erreichen, daß statt eines einzelnen p-Kanal-Transistors P1 und eines einzelnen n-Kanal-Transistors N1 jeweils mehrere gleichartige p- bzw. n-Kanal-Transistoren, die genauso dimensioniert sind und dasselbe Design bzw. Layout aufweisen wie diejenigen des zweiten I2 und des dritten I3 Inverters zur Herstellung des ersten Inverters I1 einander parallel geschaltet werden.

Die digitalen Daten auf dem Steuerbus F sind binär codiert. Das Kapazitätsnetzwerk aus den Kondensatoren C der ersten Kondensatorschaltung C1 kann ebenfalls binär gewichtet aufgebaut sein und direkt mit dem binären Code gesteuert werden. Besser ist es jedoch, wenigstens die MSB's (Most Significant Bits) der digitalen Steuersignale vorher in einen Thermometercode umzucodieren, da beim Binärcode, z. B. beim Übergang von "01111" auf "10000" das halbe Kapazitätsnetzwerk zu und die andere Hälfte weggeschaltet werden muß. Günstigerweise werden bei einem 10-Bit-Steuerwort auf dem Steuerbus F die obersten 5 Bit in den Thermometercode umcodiert. Dementsprechend ist das Kapazitätsnetzwerk aus 31 gleichgroßen Kondensatoren C für die fünf MSB's und fünf binär gewichteten Kondensatoren C für die LSB's (Least Significant Bits) aufgebaut. Beim Einsatz der Oszillatorschaltung in der geschlossenen Schleife einer PLL (Phase Locked Loop), eines der Haupteinsatzgebiete von Oszillatorschaltungen, verändert sich das digitale Steuerwort in der Rückkopplungsschleife stetig und und nicht sprunghaft, so daß zu jedem Zeitpunkt maximal 1/31 der Kapazität umgeschaltet wird.

Die in Figur 1 dargestellte Oszillatorschaltung ermöglicht ein zu dem Schwingverhalten des Oszillators synchrones Zu- und Wegschalten der Kondensatoren C der ersten Kondensatorschaltung C1. Es treten vorteilhafterweise keine Phasen- und Frequenzsprünge beim Ändern der Frequenz während des Betriebes der Oszillatorschaltung auf.

**Patentansprüche**

1. Oszillatorschaltung

   - mit einem ersten (1) und einem zweiten (2) Schaltungsknoten, die über eine Parallelschaltung aus einem Schwingquarz (O), einem ersten Inverter (I1) und einem ersten Widerstandselement (R1) miteinander verbunden sind,
   - deren erster Schaltungsknoten (1) über eine erste Kondensatorschaltung (C1) und deren zweiter Schaltungsknoten (2) über eine zweite Kondensatorschaltung (C2) mit einem Bezugspotential (Masse) verbunden ist,
   - deren erste Kondensatorschaltung (C1) wenigstens zwei Kondensatoren (C) mit je einem ersten und einem zweiten Anschluß aufweist, deren erster Anschluß mit dem Bezugspotential (Masse) und deren zweiter Anschluß über je ein Schaltelement (S) mit dem ersten Schaltungsknoten (1) verbunden ist, und mit einer Synchronisierschaltung (SY) zur Erzeugung eines Synchronisiersignals (SYNC), das ein Schalten wenigstens eines der Schaltelemente (S) in Abhängigkeit von einem Potential am ersten (1) Schaltungsknoten auslöst.

2. Oszillatorschaltung nach Anspruch 1,

   - bei der die Schaltelemente (S) jeweils einen ersten Schaltzustand haben, in dem sie den zweiten Anschluß des jeweiligen Kondensators (C) mit dem ersten Schaltungsknoten (1) verbinden, und einen zweiten Schaltzustand, in dem sie den zweiten Anschluß mit einem dritten Schaltungsknoten (3) verbinden,
   - und die eine Vorladeschaltung (V) zur Erzeugung eines Vorladepotentials aufweist, die mit dem dritten Schaltungsknoten (3) verbunden ist.

3. Oszillatorschaltung nach Anspruch 2, bei der die Synchronisierschaltung (SY) ein Schalten wenigstens eines der Schaltelemente (S) vom zweiten in den ersten Schaltzustand dann auslöst, wenn das Potential am ersten Schaltungsknoten (1) im wesentlichen mit dem Vorladepotential am dritten Schaltungsknoten (3) übereinstimmt.

4. Oszillatorschaltung nach Anspruch 2 oder 3,

   - bei der der erste Inverter (I1) einen Transistor eines ersten Leitungstyps (P1) und einen Transistor eines zweiten Leitungstyps (N1) aufweist,
   - bei der die Vorladeschaltung (V) einen zweiten Inverter (I2) mit einem Transistor des ersten Leitungstyps (P2) und mit einem Transistor des zweiten Leitungstyps (N2) und ein dem zweiten Inverter (I2) parallel geschaltetes zweites Widerstandselement (R2) aufweist, wobei ein Eingang oder Ausgang des zweiten Inverters (I2) mit dem dritten Schaltungsknoten (3) verbunden ist,
   - und bei der der Quotient aus dem Weiten-zu-Längen-Verhältnis des Transistors des ersten Leitungstyps (P1; P2) und dem Weiten-zu-Längen-Verhältnis des Transistors des zweiten Leitungstyps (N1; N2) für den ersten (I1) und den zweiten (I2) Inverter im wesentlichen übereinstimmt.

**5.** Oszillatorschaltung nach einem der vorstehenden Ansprüche,

- bei der der erste Inverter (I1) einen Transistor eines ersten Leitungstyps (P1) und einen Transistor eines zweiten Leitungstyps (N1) aufweist,
- bei der die Synchronisierschaltung (SY) einen dritten Inverter (I3) mit einem Transistor des ersten Leitungstyps (P3) und mit einem Transistor des zweiten Leitungstyps (N3) aufweist, wobei ein Eingang des dritten Inverters (I3) mit dem ersten (1) Schaltungsknoten verbunden ist und ein Ausgang des dritten Inverters (I3) zur Bereitstellung des Synchronisiersignals (SYNC) dient,
- und bei der der Quotient aus dem Weiten-zu-Längen-Verhältnis des Transistors des ersten Leitungstyps (P1; P3) und dem Weiten-zu-Längen-Verhältnis des Transistors des zweiten Leitungstyps (N1; N3) für den ersten (I1) und den dritten (I3) Inverter im wesentlichen übereinstimmt.

**6.** Oszillatorschaltung nach Anspruch 4 oder 5, bei der der erste (I1), der zweite (I2) und/oder der dritte (I3) Inverter CMOS-Inverter sind.

**Claims**

**1.** Oscillator circuit having a first (1) and a second (2) circuit node which are interconnected via a parallel circuit of a quartz resonator (O), a first inverter (I1) and a first resistor element (R1),

- whose first circuit node (1) is connected to a reference potential (frame) via a first capacitor circuit (C1), and whose second circuit node (2) is connected to a reference potential (frame) via a second capacitor circuit (C2), and
- whose first capacitor circuit (C1) has at least two capacitors (C) with a first and a second terminal each, whose first terminal is connected to the reference potential (frame) and whose second terminal is connected to the first circuit node (1) via one switching element each, and having a synchronizing circuit (SY) for generating a synchronizing signal (SYNC) which triggers switching of at least one of the switching elements (S) as a function of a potential at the first (1) circuit node.

**2.** Oscillator circuit according to Claim 1,

- in which the switching elements (S) in each case have a first switching state in which they connect the second terminal of the respective capacitor (C) to the first circuit node (1), and a second switching state in which they connect the second terminal to a third circuit node (3),
- and which has, for the purpose of generating a precharging potential, a precharging circuit (V) which is connected to the third circuit node (3).

**3.** Oscillator circuit according to Claim 2, in which the synchronizing circuit (SY) triggers switching of at least one of the switching elements (S) from the second into the first switching state whenever the potential at the first circuit node (1) essentially corresponds to the precharging potential at the third circuit node (3).

**4.** Oscillator circuit according to Claim 2 or 3,

- in which the first inverter (I1) has a transistor of a first conductivity type (P1) and a transistor of a second conductivity type (N1),
- in which the precharging circuit (V) has a second inverter (I2) with a transistor of the first conductivity type (P2) and with a transistor of the second conductivity type (N2), and a second resistor element (R2), which is connected in parallel with the second inverter (I2), an input or output of the second inverter (I2) being connected to the third circuit node (3),
- and in which the quotient of the width-to-length ratio of the transistor of the first conductivity type (P1; P2) to the width-to-length ratio of the transistor of the second conductivity type (N1; N2) essentially corresponds for the first (I1) and the second (I2) inverter.

**5.** Oscillator circuit according to one of the preceding claims,

- in which the first inverter (I1) has a transistor of a first conductivity type (P1) and a transistor of a second conductivity type (N1),
- in which the synchronizing circuit (SY) has a third inverter (I3) with a transistor of the first conductivity type (P3) and with a transistor of the second conductivity type (N3), an input of the third inverter (I3) being connected to the first (1) circuit node, and an output of the third inverter (I3) serving to provide the synchronizing signal (SYNC),
- and in which the quotient of the width-to-length ratio of the transistor of the first conductivity type (P1; P3) to the width-to-length ratio of the transistor of the second conductivity type (N1; N3) essentially corresponds for the first (I1) and the third (I3) inverter.

**6.** Oscillator circuit according to Claim 4 or 5, in which the first (I1), the second (I2) and/or the third (I3) inverter are CMOS inverters.

## Revendications

1. Circuit oscillateur

   - présentant un premier noeud de circuit (1) et un deuxième noeud de circuit (2) qui sont reliés l'un à l'autre par un circuit parallèle constitué d'un quartz piézoélectrique (O), d'un premier inverseur (I1) et d'un premier élément à résistance (R1),
   - dont le premier noeud de circuit (1) est relié à un potentiel de référence (masse) par un premier circuit de condensateurs (C1) et dont le deuxième noeud de circuit (2) est relié au potentiel de référence (masse) par un deuxième circuit de condensateurs (C2),
   - dont le premier circuit de condensateurs (C1) présente au moins deux condensateurs (C) qui présentent chacun une première et une deuxième borne de raccordement, dont la première borne de raccordement est reliée au potentiel de référence (masse) et dont la deuxième borne de raccordement est reliée au premier noeud de circuit (1), chaque fois par un élément de commutation (S),

   et présentant un circuit de synchronisation (SY) pour la création d'un signal de synchronisation (SYNC) qui déclenche une commutation d'au moins l'un des éléments de commutation (S) sous la dépendance d'un potentiel au premier noeud de circuit (1).

2. Circuit oscillateur selon la revendication 1,

   - dans lequel les éléments de commutation (S) présentent chaque fois un premier état de commutation dans lequel ils relient la deuxième borne de raccordement du condensateur (C) concerné au premier noeud de circuit (1) et un deuxième état de commutation dans lequel ils relient la deuxième borne de raccordement à un troisième noeud de circuit (3),
   - et qui présente un circuit de précharge (V) qui est relié au troisième noeud de circuit (3), pour la création d'un potentiel de précharge.

3. Circuit oscillateur selon la revendication 2, dans lequel le circuit de synchronisation (SY) déclenche une commutation d'au moins l'un des éléments de commutation (S) depuis le deuxième jusque dans le premier état de commutation lorsque le potentiel au premier noeud de circuit (1) correspond essentiellement au potentiel de précharge au troisième noeud de circuit (3).

4. Circuit oscillateur selon la revendication 2 ou 3,

   - dans lequel le premier inverseur (I1) présente un transistor d'un premier type de conductivité (P1) et un transistor d'un deuxième type de conductivité (N1),
   - dans lequel le circuit de précharge (V) présente un deuxième inverseur (I2) doté d'un transistor du premier type de conductivité (P2) et d'un transistor du deuxième type de conductivité (N2), et un deuxième élément à résistance (R2) branché en parallèle sur le deuxième inverseur (I2), une entrée ou une sortie du deuxième inverseur (I2) étant reliée au troisième noeud de circuit (3),
   - et dans lequel le quotient du rapport largeur-longueur du transistor du premier type de conductivité (P1 ; P2) et du rapport largeur-longueur du transistor du deuxième type de conductivité (N1 ; N2) du premier inverseur (I1) et du deuxième inverseur (I2) se correspondent essentiellement.

5. Circuit oscillateur selon l'une des revendications précédentes,

   - dans lequel le premier inverseur (I1) présente un transistor d'un premier type de conductivité (P1) et un transistor d'un deuxième type de conductivité (N1),
   - dans lequel le circuit de synchronisation (SY) présente un troisième inverseur (I3) doté d'un transistor du premier type de conductivité (P3) et d'un transistor du deuxième type de conductivité (N3), une entrée du troisième inverseur (I3) étant reliée au premier noeud de circuit (1), et une sortie du troisième inverseur (I3) servant à préparer le signal de synchronisation (SYNC),
   - et dans lequel le quotient du rapport largeur-longueur du transistor du premier type de conductivité (P1 ; P3) et du rapport largeur-longueur du transistor du deuxième type de conductivité (N1 ; N3) du premier inverseur (I1) et du troisième inverseur (I3) se correspondent essentiellement.

6. Circuit oscillateur selon la revendication 4 ou 5, dans lequel le premier inverseur (I1), le deuxième inverseur (I2) et/ou le troisième inverseur (I3) sont des inverseurs CMOS.

# FIG 1

FIG 2

FIG 3